(19) Europäisches Patentamt
European Patent Office
Office européen des brevets

(11) **EP 4 669 069 A1**

(12) **EUROPEAN PATENT APPLICATION**
published in accordance with Art. 153(4) EPC

(43) Date of publication:
**24.12.2025 Bulletin 2025/52**

(21) Application number: 24756972.6

(22) Date of filing: **15.02.2024**

(51) International Patent Classification (IPC):
**H10K 50/844** (2023.01)    **H01L 23/14** (2006.01)
**H10K 50/10** (2023.01)    **H10K 77/10** (2023.01)

(52) Cooperative Patent Classification (CPC):
**H01L 23/14; H10K 50/10; H10K 50/844;
H10K 77/10;** Y02E 10/549

(86) International application number:
**PCT/JP2024/005356**

(87) International publication number:
**WO 2024/172132 (22.08.2024 Gazette 2024/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.02.2023   JP 2023022749**

(71) Applicant: **AJINOMOTO CO., INC.
Chuo-ku
Tokyo 104-8315 (JP)**

(72) Inventors:
• **OHASHI, Satoru**
**Kawasaki-shi, Kanagawa 210-0801 (JP)**
• **NATORI, Naoki**
**Kawasaki-shi, Kanagawa 210-0801 (JP)**
• **OKUNO, Manami**
**Kawasaki-shi, Kanagawa 210-0801 (JP)**
• **HOSOI, Mai**
**Kawasaki-shi, Kanagawa 210-0801 (JP)**
• **ASATO, Luis**
**Kawasaki-shi, Kanagawa 210-0801 (JP)**

(74) Representative: **Mewburn Ellis LLP
Aurora Building
Counterslip
Bristol BS1 6BX (GB)**

(54) **ELECTRONIC DEVICE**

(57)    The present invention aims to provide an electronic device that suppresses warping, can sufficiently protect electronic elements from water vapor, and is superior in folding resistance, even though it includes a flexible substrate. The present invention relates to an electronic device having a flexible substrate, an electronic element formed on the flexible substrate, and a sealing layer that seals the electronic element, the electronic device further including a barrier film provided via an adhesive layer on a surface of the flexible substrate opposite to the surface on which the electronic element is formed, and the adhesive layer containing a polymer containing constitutional units derived from isobutene.

## Description

[Technical Field]

The present invention relates to an electronic device.

[Background Art]

In the production of electronic devices, electronic elements are produced on a glass substrate or the like and then sealed by covering the electronic elements in order to protect electronic elements vulnerable to moisture. On the other hand, in order to produce a foldable electronic device, it is necessary to use a flexible substrate as a substrate having a certain degree of flexibility. While thin glass can be used in the production of a foldable electronic device, it is desirable to use a plastic substrate as a flexible substrate because there is a concern that the thin glass may break during the production step of the foldable electronic device.

Patent Literature 1 discloses a method for producing an organic electronic device in which an element substrate is sealed with a sealing member with an adhesive layer laminated on a sealing substrate. Patent Literature 1 exemplifies a plastic film or the like as a substrate. Patent Literature 1 also teaches that the substrate may have a barrier layer.

[Citation List]

[Patent Literature]

[Patent Literature 1]
JP 2019-67493 A

[Summary of Invention]

[Technical Problem]

When a plastic substrate is used as a flexible substrate, since the plastic substrate is inferior in water vapor barrier property to glass substrates, a barrier layer may be provided on the plastic substrate as shown in Patent Literature 1. However, when a plastic substrate (e.g., a barrier film) provided with a barrier layer is used as a flexible substrate and an electronic element is formed on the substrate, a problem occurs in that the substrate is prone to warping based on the difference in thermal expansion coefficient between the plastic substrate and the barrier layer due to the thermal history at that time. Also, when a plastic substrate provided with a barrier layer is used as a flexible substrate and an electronic device is produced, a problem occurs in that the barrier layer is damaged during the production step and the barrier function of the substrate is reduced. In addition, a foldable electronic device is required to be less likely to generate air bubbles, etc. in the adhesive layer and the like, even when repeatedly folded (i.e., superior in folding resistance).

The present invention has been made in consideration of the aforementioned circumstances, and aims to provide an electronic device that suppresses warping, can sufficiently protect electronic elements from water vapor, and is superior in folding resistance, even though it includes a flexible substrate.

[Solution to Problem]

An electronic device capable of achieving the above-mentioned object is as follows.

[1] An electronic device having

a flexible substrate,
an electronic element formed on the aforementioned flexible substrate, and
a sealing layer that seals the aforementioned electronic element,
the aforementioned electronic device further comprising a barrier film provided via an adhesive layer on a surface of the aforementioned flexible substrate opposite to a surface on which the electronic element is formed, and
the aforementioned adhesive layer comprising a polymer comprising constitutional units derived from isobutene.

[2] The electronic device of the aforementioned [1], wherein the aforementioned adhesive layer comprises a crosslinked polymer having an isobutene-isoprene copolymer chain.
[3] The electronic device of the aforementioned [1] or [2], wherein the aforementioned adhesive layer comprises a hygroscopic filler.

[4] The electronic device of any one of the aforementioned [1] to [3], wherein the aforementioned barrier film has a total light transmittance of 80% or more.

[5] The electronic device of any one of the aforementioned [1] to [4], wherein the aforementioned electronic element is an organic light-emitting diode element or a photoelectric conversion element.

[Advantageous Effects of Invention]

The electronic device of the present invention suppresses warping, can sufficiently protect electronic elements from water vapor, and is superior in folding resistance, even though it includes a flexible substrate.

[Description of Embodiments]

The electronic device of the present invention has a flexible substrate, an electronic element formed on the aforementioned flexible substrate, and a sealing layer that seals the aforementioned electronic element. The electronic device of the present invention is characterized in that it has a barrier film provided via an adhesive layer on a surface of the aforementioned flexible substrate opposite to the surface on which the electronic element is formed, and the aforementioned adhesive layer contains a polymer containing constitutional units derived from isobutene. In the electronic device of the present invention having such configuration, a barrier film can be provided via an adhesive layer, after forming the electronic element on the flexible substrate, on a surface of the aforementioned flexible substrate opposite to the surface on which the electronic element is formed. Therefore, the barrier film is not subjected to the thermal history during the formation of the electronic element, and the occurrence of warping and the decrease in water vapor barrier property can be suppressed. In addition, in the present invention, by using a polymer containing constitutional units derived from isobutene, the occurrence of bubbles in the adhesive layer can be suppressed even if the electronic device of the present invention is folded repeatedly. The adhesive layer and barrier film, which are the characteristics of the present invention, are described below.

The adhesive layer contains a polymer containing constitutional units derived from isobutene (hereinafter sometimes to be abbreviated as "isobutene polymer"). In the present specification, the "constitutional unit derived from isobutene" is sometimes abbreviated as "isobutene unit". The "constitutional unit derived from other monomer" is also sometimes abbreviated in the same manner. Only one kind of isobutene polymer may be used, or two or more kinds thereof may be used in combination.

From the aspect of folding resistance, the amount of isobutene unit in the isobutene polymer is preferably 80 to 100% by mass, more preferably 85 to 100% by mass, further preferably 90 to 100% by mass, based on the entire constitutional units of the isobutene polymer. The amount of the aforementioned isobutene units is based on the entire constitutional units (i.e., repeating units) excluding modified parts (e.g., parts derived from maleic anhydride for acid anhydride group introduction).

The isobutene polymer may contain constitutional units derived from acrylic acid, acrylic acid esters, methacrylic acid or methacrylic acid esters (hereinafter sometimes to be abbreviated as "(meth)acrylic units") in order to introduce a reactive functional group for forming a crosslinked structure. From the aspect of maintaining adhesiveness under high temperature and high humidity, the amount of (meth)acrylic unit in the isobutene polymer is preferably 40% by mass or less, more preferably 35% by mass or less, further preferably 30% by mass or less, based on the entire isobutene polymer.

The number average molecular weight of the polymer containing isobutene units is preferably 500 to 500,000, more preferably 600 to 400,000, further preferably 700 to 300,000, from the aspect of ensuring adhesiveness when folded. The number average molecular weight in the present specification is measured by a gel permeation chromatography (GPC) method (based on polystyrene). Specifically, the number average molecular weight by the GPC method can be measured using "LC-9A/RID-6A" manufactured by Shimadzu Corporation as a measuring apparatus, "Shodex K-800P/K-804L/K-804L" manufactured by Showa Denko K.K. as a column, and toluene or the like as a mobile phase at a column temperature of 40°C, and calculated using a standard polystyrene calibration curve.

From the aspect of folding resistance, the content of the isobutene polymer in the adhesive layer is preferably 20 to 90% by mass, more preferably 25 to 85% by mass, further preferably 30 to 80% by mass, based on the entire adhesive layer.

As described below, the adhesive layer may contain a hygroscopic filler. From the aspect of folding resistance, the content of the isobutene polymer in the adhesive layer is preferably 50 to 80% by mass, more preferably 55 to 80% by mass, based on the total of components other than the hygroscopic filler in the adhesive layer.

The isobutene polymer is preferably an isobutene-isoprene copolymer (i.e., butyl rubber). Only one kind of isobutene-isoprene copolymer may be used, or, for example, two or more kinds of isobutene-isoprene copolymers having different amounts of isobutene units may be used. From the aspect of folding resistance, the amount of isobutene unit in the isobutene-isoprene copolymer is preferably 80 to 99.9% by mass, more preferably 85 to 99.7% by mass, further preferably 90 to 99.5% by mass, based on the total of isobutene unit and isoprene unit. The amount of the aforementioned isobutene unit is based on the isobutene unit and isoprene unit excluding modified parts (e.g., parts derived from maleic anhydride for acid anhydride group introduction).

The isobutene-isoprene copolymer may contain (meth)acrylic units in order to introduce a reactive functional group for forming a crosslinked structure. From the aspect of maintaining adhesiveness under high temperature and high humidity, the amount of (meth)acrylic unit in the isobutene-isoprene copolymer is preferably 40% by mass or less, more preferably 35% by mass or less, and further preferably 30% by mass or less, based on the entire isobutene-isoprene copolymer.

The number average molecular weight of the isobutene-isoprene copolymer is preferably 5,000 to 500,000, more preferably 10,000 to 400,000, further preferably 20,000 to 300,000, from the aspect of ensuring adhesiveness when folded.

From the aspect of folding resistance, the content of the isobutene-isoprene copolymer in the adhesive layer is preferably 5 to 65% by mass, more preferably 5 to 60% by mass, further preferably 7 to 55% by mass, based on the entire adhesive layer.

From the aspect of folding resistance, the content of the isobutene-isoprene copolymer in the adhesive layer is preferably 5 to 65% by mass, more preferably 7 to 60% by mass, further preferably 10 to 55% by mass, based on the total of components other than the hygroscopic filler in the adhesive layer.

The isobutene-isoprene copolymer preferably forms a crosslinked structure in the adhesive layer for folding resistance. In other words, the adhesive layer preferably contains, for folding resistance, a crosslinked polymer having an isobutene-isoprene copolymer chain (hereinafter sometimes referred to as "crosslinked polymer (A)"). The crosslinked polymer (A) is preferably a crosslinked polymer formed from an isobutene-isoprene copolymer having a reactive functional group (hereinafter sometimes referred to as "the first reactive functional group") (i.e., butyl rubber having the first reactive functional group) and an olefin-based polymer having a reactive functional group capable of reacting with the first reactive functional group (hereinafter sometimes referred to as "second reactive functional group"). In the present specification, the "olefin-based polymer" means a polymer in which the olefin unit is the main constitutional unit (that is, the amount of olefin unit is the largest of all constitutional units). Only one kind of crosslinked polymer (A) may be used or two or more kinds thereof may be used in combination.

As the olefin, a monoolefin having one olefinic carbon-carbon double bond and/or a diolefin having two olefinic carbon-carbon double bonds are/is preferred. Examples of the monoolefin include α-olefins such as ethylene, propylene, 1-butene, isobutene (isobutylene), 1-pentene, 1-hexene, 1-heptene, 1-octene, and the like. Examples of the diolefin include 1,3-butadiene, isoprene, 1,3-pentadiene, 2,3-dimethylbutadiene, and the like.

The olefin-based polymer may be a homopolymer or a copolymer. The copolymer may be a random copolymer or a block copolymer. The olefin-based polymer may be a copolymer of olefin and a monomer other than olefin. Examples of the olefin-based copolymer include isobutene-isoprene copolymer (i.e., butyl rubber), ethylene-nonconjugated diene copolymer, ethylene-propylene copolymer, ethylene-propylene-nonconjugated diene copolymer, ethylene-butene copolymer, propylene-butene copolymer, propylene-butene-nonconjugated diene copolymer, styrene-isobutene copolymer, styrene-isobutene-styrene copolymer, and the like.

The olefin-based polymer may contain a (meth)acrylic unit. From the aspect of maintaining adhesiveness under high temperature and high humidity, the amount of (meth)acrylic unit in the olefin-based polymer is preferably 40% by mass or less, more preferably 35% by mass or less, further preferably 30% by mass or less, based on the entire olefin-based polymer.

The olefin-based polymer having the second reactive functional group is preferably a butene-based polymer having the second reactive functional group. Here, the "butene-based polymer" means a polymer in which the butene unit is the main constitutional unit (that is, the amount of butene unit is the largest of all constitutional units). Examples of the butene include 1-butene, isobutene, and the like. Examples of the butene-based polymer include polybutene, isobutene-isoprene copolymer, styrene-isobutene-styrene copolymer, and the like. Polybutene may be a homopolymer (e.g., 1-butene homopolymer, isobutene homopolymer) or a copolymer (e.g., copolymer of 1-butene and isobutene, copolymer of isobutene and isoprene).

In order to form the crosslinked polymer (A), each of the isobutene-isoprene copolymer having the first reactive functional group and the olefin polymer having the second reactive functional group may be used alone or two or more kinds thereof may be used in combination.

Examples of the combination of the first reactive functional group with the second reactive functional group include a combination of an epoxy group with a carboxy group and/or an acid anhydride group (i.e., carbonyloxycarbonyl group (-CO-O-CO-)), a combination of a carboxy group and/or an acid anhydride group with an epoxy group, a combination of an epoxy group with an amino group, a combination of an amino group with an epoxy group, a combination of a hydroxy group with an isocyanate group (i.e., isocyanato group), a combination of an isocyanate group with a hydroxy group, and the like. Among these, from the aspect of water vapor barrier property, the combination of an epoxy group with a carboxy group and/or an acid anhydride group, and the combination of a carboxy group and/or an acid anhydride group with an epoxy group are preferred, and the combination of an epoxy group with an acid anhydride group, and the combination of an acid anhydride group with an epoxy group are more preferred. In the aforementioned combinations, the former reactive functional group is the first reactive functional group, and the latter reactive functional group is the second reactive functional group.

In one embodiment of the present invention, the crosslinked polymer (A) is preferably at least one selected from the group consisting of a reaction product of an isobutene-isoprene copolymer having an epoxy group and an olefin-based polymer having a carboxy group and/or an acid anhydride group, and a reaction product of an isobutene-isoprene copolymer having a carboxy group and/or an acid anhydride group and an olefin-based polymer having an epoxy group. In the aforementioned embodiment, the olefin polymer is preferably butene-based polymer, more preferably a mixture of polybutene and isobutene-isoprene copolymer, isobutene-isoprene copolymer, or polybutene, further preferably a mixture of polyisobutene and isobutene-isoprene copolymer, isobutene-isoprene copolymer, or polyisobutene, particularly preferably a mixture of polyisobutene and isobutene-isoprene copolymer, or polyisobutene. In the aforementioned embodiment, the carboxy group and/or acid anhydride group is preferably an acid anhydride group.

The amount of the isobutene-isoprene copolymer having a reactive functional group (e.g., epoxy group, carboxy group and/or acid anhydride group) to be used is preferably 50 to 100% by mass, more preferably 55 to 100% by mass, further preferably 60 to 97% by mass, based on the total amount of polymers to be used to form the crosslinked polymer (A) (e.g., the total amount of isobutene-isoprene copolymer having the first reactive functional group and olefin-based polymer having the second reactive functional group). When an isobutene-isoprene copolymer having the first reactive functional group and an isobutene-isoprene copolymer having the second reactive functional group are used to form the crosslinked polymer (A), the "amount of isobutene-isoprene copolymer having a reactive functional group" refers to the "total amount of isobutene-isoprene copolymer having the first reactive functional group and isobutene-isoprene copolymer having the second reactive functional group".

The number average molecular weight of the isobutene-isoprene copolymer having a reactive functional group (e.g., epoxy group, carboxy group, and/or acid anhydride group) for forming the crosslinked polymer (A) is preferably 5,000 to 500,000, more preferably 10,000 to 400,000, further preferably 20,000 to 300,000.

The number average molecular weight of the olefin-based polymer (excluding isobutene-isoprene copolymer) having the second reactive functional group (e.g., epoxy group, carboxy group, and/or acid anhydride group) for forming the crosslinked polymer (A) is preferably 250 to 500,000, more preferably 500 to 300,000, further preferably 750 to 200,000.

From the aspect of folding resistance, the amount of isobutene unit in the isobutene-isoprene copolymer having a reactive functional group (e.g., epoxy group, carboxy group, and/or acid anhydride group) for forming the crosslinked polymer (A) is preferably 80 to 99.9% by mass, more preferably 85 to 99.7% by mass, further preferably 90 to 99.5% by mass, each per a total of isobutene unit and isoprene unit. The amount of the aforementioned isobutene unit is based on the isobutene unit and isoprene unit excluding modified parts (e.g., parts derived from maleic anhydride for acid anhydride group introduction).

The concentration of epoxy group in the olefin-based polymer having an epoxy group (e.g., isobutene-isoprene copolymer having an epoxy group, polybutene having an epoxy group) for forming the crosslinked polymer (A) is preferably 0.01 to 10 mmol/g, more preferably 0.05 to 5 mmol/g. The epoxy group concentration is determined from the epoxy equivalent obtained based on JIS K 7236-1995.

The concentration of carboxy group in the olefin-based polymer having a carboxy group (e.g., isobutene-isoprene copolymer having a carboxy group, polybutene having a carboxy group) for forming the crosslinked polymer (A) is preferably 0.01 to 10 mmol/g, more preferably 0.05 to 5 mmol/g. The concentration of the carboxy group is obtained from the acid value defined as the number of milligram of potassium hydroxide necessary for neutralizing the acid present in 1 g of a resin according to the description of JIS K 2501.

The concentration of acid anhydride group in the olefin-based polymer having an acid anhydride group (e.g., isobutene-isoprene copolymer having an acid anhydride group, polybutene having an acid anhydride group) for forming the crosslinked polymer (A) is preferably 0.01 to 10 mmol/g, more preferably 0.05 to 5 mmol/g. The concentration of the acid anhydride group is obtained from the acid value defined as the number of milligram of potassium hydroxide necessary for neutralizing the acid present in 1 g of a resin according to the description of JIS K 2501.

The total of the concentration of carboxy groups and the concentration of acid anhydride groups in the olefin-based polymer having a carboxy group and an acid anhydride group (e.g., isobutene-isoprene copolymer having a carboxy group and an acid anhydride group, or polybutene having a carboxy group and an acid anhydride group) for forming the crosslinked polymer (A) is preferably 0.01 to 10 mmol/g, more preferably 0.05 to 5 mmol/g.

The amounts of the isobutene-isoprene copolymer having an epoxy group and the olefin-based polymer having a carboxy group (e.g., isobutene-isoprene copolymer having a carboxy group, polybutene having a carboxy group) to be used are not particularly limited as long as the crosslinked polymer (A) can be formed. The ratio of the amount (mol) of the epoxy group to the amount (mol) of the carboxy group (i.e., amount (mol) of epoxy group:amount (mol) of carboxy group) is preferably 100:10 to 100:500, more preferably 100:25 to 100:475, further preferably 100:40 to 100:450.

The amounts of the isobutene-isoprene copolymer having an epoxy group and the olefin-based polymer having an acid anhydride group (e.g., isobutene-isoprene copolymer having an acid anhydride group, polybutene having an acid anhydride group) to be used are not particularly limited as long as the crosslinked polymer (A) can be formed. The ratio of the amount (mol) of the epoxy group to the amount (mol) of the acid anhydride group (i.e., amount (mol) of epoxy group:amount (mol) of acid anhydride group) is preferably 100:10 to 100:500, more preferably 100:25 to 100:475, further preferably 100:40 to 100:450.

The amounts of the isobutene-isoprene copolymer having an epoxy group and the olefin-based polymer having a carboxy group and an acid anhydride group (e.g., isobutene-isoprene copolymer having a carboxy group and an acid anhydride group, polybutene having a carboxy group and an acid anhydride group) to be used are not particularly limited as long as the crosslinked polymer (A) can be formed. The ratio of "the amount (mol) of the epoxy group" to "the total of the amount (mol) of the carboxy group and the amount (mol) of the acid anhydride group" (i.e., amount (mol) of epoxy group: (amount (mol) of carboxy group + amount (mol) of acid anhydride group)) is preferably 100:10 to 100:500, more preferably 100:25 to 100:475, further preferably 100:40 to 100:450.

The olefin-based polymer having an epoxy group (for example, isobutene-isoprene copolymer having epoxy group, polybutene having epoxy group) can be obtained by graft modification of an olefin-based polymer with an unsaturated compound having an epoxy group (e.g., glycidyl (meth)acrylate, 4-hydroxybutyl acrylate glycidyl ether, allyl glycidyl ether) under radical reaction conditions.

The olefin-based polymer having an epoxy group may be a commercially available product. Examples of the commercially available product of the isobutene-isoprene copolymer having an epoxy group include "ER866" (glycidyl methacrylate-modified isobutene-isoprene copolymer) manufactured by SEIKO PMC CORPORATION, "ER850" (glycidyl methacrylate-modified isobutene-isoprene copolymer) manufactured by SEIKO PMC CORPORATION, and the like. Examples of the commercially available product of the olefin-based polymer having an epoxy group (excluding isobutene-isoprene copolymer) include "T-YP341" (glycidyl methacrylate-modified propylene-butene random copolymer) manufactured by SEIKO PMC CORPORATION, "T-YP276" (glycidyl methacrylate-modified propylene-butene random copolymer) manufactured by SEIKO PMC CORPORATION, "T-YP313" (glycidyl methacrylate-modified propylene-butene random copolymer) manufactured by SEIKO PMC CORPORATION, and the like.

The olefin-based polymer having a carboxy group and/or an acid anhydride group (e.g., isobutene-isoprene copolymer having carboxy group and/or acid anhydride group, polybutene having carboxy group and/or polybutene having acid anhydride group) can be obtained by graft modification of an olefin-based polymer with an unsaturated compound having a carboxy group and/or an acid anhydride group (e.g., maleic anhydride) under radical reaction conditions.

The olefin-based polymer having a carboxy group and/or an acid anhydride group may be a commercially available product. Examples of the commercially available product of the isobutene-isoprene copolymer having a carboxy group and/or an acid anhydride group include "ER661" (maleic anhydride-modified isobutene-isoprene copolymer) manufactured by SEIKO PMC CORPORATION, "ER641" (maleic anhydride-modified isobutene-isoprene copolymer) manufactured by SEIKO PMC CORPORATION, and the like. Examples of the commercially available product of the olefin-based polymer having a carboxy group and/or an acid anhydride group (excluding isobutene-isoprene copolymer) include "HV-300M" (maleic anhydride-modified polyisobutene) manufactured by TOHO CHEMICAL INDUSTRY COMPANY, LIMITED, "T-YP279" (maleic anhydride-modified propylene-butene random copolymer) manufactured by SEIKO PMC CORPORATION, "T-YP312" (maleic anhydride-modified propylene-butene random copolymer) manufactured by SEIKO PMC CORPORATION, "LUCANT A-5260" (maleic anhydride-modified ethylene-$\alpha$-olefin random copolymer), and "LUCANT A-5320" (maleic anhydride-modified ethylene-$\alpha$-olefin random copolymer) manufactured by Mitsui Chemicals, Inc., and the like.

From the aspect of folding resistance, the content of the crosslinked polymer (A) in the adhesive layer is preferably 5 to 65% by mass, more preferably 10 to 60% by mass, further preferably 10 to 55% by mass, based on the entire adhesive layer.

From the aspect of folding resistance, the content of the crosslinked polymer (A) in the adhesive layer is preferably 5 to 65% by mass, more preferably 10 to 60% by mass, further preferably 15 to 55% by mass, based on the total of components other than the hygroscopic filler in the adhesive layer.

From the aspect of adhesiveness, the adhesive layer preferably contains a liquid polyolefin-based resin and/or a liquid rubber (hereinafter sometimes to be abbreviated as "liquid polymer"). Only one kind of liquid polymer may be used, or two or more kinds thereof may be used in combination. By using a liquid polymer, good adhesiveness can be achieved.

In the present specification, the "liquid" means that the viscosity at 25°C is not more than 5,000 Pa·s. In the present invention, "the viscosity at 25°C" means a viscosity calculated by multiplying the kinematic viscosity at 25°C, measured by a dynamic viscoelasticity measuring device, by the density. Examples of the dynamic viscoelasticity measuring device include a rheometer (trade name: DISCOVERY HR-2) manufactured by TA Instruments and the like.

With regard to the liquid polymer, the "liquid polyolefin-based resin" means an olefin-based polymer having a viscosity of 5,000 Pa·s or less at 25°C, which cannot form a rubber elastomer by crosslinking, and the "liquid rubber" means one having a viscosity of 5,000 Pa·s or less at 25°C, which can form a rubber elastomer by crosslinking. For example, liquid polyisoprene is classified as a liquid rubber because it can form a rubber elastomer by crosslinking.

The liquid polymer may contain a (meth)acrylic unit. From the aspect of maintaining adhesiveness under high temperature and high humidity, the amount of (meth)acrylic unit in the liquid polymer is preferably 10% by mass or less based on the entire liquid polymer. More preferably, the liquid polymer does not contain a (meth)acrylic unit.

The viscosities of the liquid polyolefin-based resin and the liquid rubber at 25°C are each preferably 5 to 5,000 Pa·s, more preferably 10 to 4,000 Pa·s, further preferably 20 to 3,000 Pa·s.

The number average molecular weight of the liquid polyolefin-based resin is preferably 500 to 15,000, more preferably 750 to 12,500, further preferably 1,000 to 10,000. The number average molecular weight of the liquid rubber is preferably 500 to 15,000, more preferably 750 to 12,500, further preferably 1,000 to 10,000.

The liquid polymer is preferably a liquid polybutene containing isobutene units, more preferably liquid polyisobutene.

As the liquid polymer, a commercially available product can be used. Examples of the commercially available product of isobutene unit-containing liquid polyolefin-based resin include "HV-300" (liquid polybutene) manufactured by ENEOS, "HV-1900" (liquid polyisobutene) manufactured by ENEOS, "HV-50" (liquid polybutene) manufactured by ENEOS, "HV-35" (liquid polybutene) manufactured by ENEOS, "950MW" (liquid polybutene) manufactured by Kothari, "2400MW" manufactured by Kothari, "H-1900" (liquid polybutene) manufactured by INEOS, "H-6000" (liquid polybutene) manufactured by INEOS, "H-18000" (liquid polybutene) manufactured by INEOS, and "200N" (liquid polybutene) manufactured by NOF CORPORATION.

The liquid polymer may not contain an isobutene unit. Examples of the commercially available product of the liquid polyolefin-based resin not containing isobutene include "BI-2000" (hydrogenated polybutadiene) manufactured by Nippon Soda Co., Ltd., "BI-3000" (hydrogenated polybutadiene) manufactured by Nippon Soda Co., Ltd., "GI-3000" (hydrogenated polybutadiene) manufactured by Nippon Soda Co., Ltd., "LUCANT LX100" (liquid olefin-based polymer) manufactured by Mitsui Chemicals, Inc., "LUCANT LX400" (liquid olefin-based polymer) manufactured by Mitsui Chemicals, Inc., and the like. Examples of the commercially available product of liquid rubber not containing an isobutene unit include "Poly bd R-45HT" (liquid butadiene-based rubber) manufactured by Idemitsu Showa Shell, "Poly bd R-15HT" (liquid butadiene-based rubber) manufactured by Idemitsu Showa Shell, "Poly ip" (liquid polyisoprene) manufactured by Idemitsu Showa Shell, "B-1000" (liquid polybutadiene) manufactured by Nippon Soda Co., Ltd., "B-3000" (liquid polybutadiene) manufactured by Nippon Soda Co., Ltd., "G-3000" (liquid polybutadiene) manufactured by Nippon Soda Co., Ltd., "LIR-30" (liquid polyisoprene) manufactured by KURARAY CO., LTD., "LIR-390" (liquid polyisoprene) manufactured by KURARAY CO., LTD., "LIR-290" (liquid polyisoprene) manufactured by KURARAY CO., LTD., "LBR-302" (liquid polybutadiene) manufactured by KURARAY CO., LTD., "LBR-305" (liquid polybutadiene) manufactured by KURARAY CO., LTD., "LBR-361" (liquid polybutadiene) manufactured by KURARAY CO., LTD., "L-SBR-820" (liquid styrene-butadiene random copolymer) manufactured by KURARAY CO., LTD., "Ricon154" (liquid butadiene) manufactured by CRAY VALLEY, "RICON 184" (liquid styrene-butadiene random copolymer) manufactured by CRAY VALLEY, and the like.

When a liquid polymer is used, the content of the liquid polymer in the adhesive layer (when both a liquid polyolefin-based resin and liquid rubber are used, the total content of these) is preferably 10 to 50% by mass, more preferably 15 to 45% by mass, based on the entire adhesive layer, from the aspect of adhesiveness.

When a liquid polymer is used, the content of the liquid polymer in the adhesive layer is preferably 15 to 60% by mass, and more preferably 20 to 55% by mass, based on the total of components other than the hygroscopic filler in the adhesive layer, from the aspect of folding resistance.

The adhesive layer preferably contains a hygroscopic filler in order to achieve good water vapor barrier property. Only one kind of hygroscopic filler may be used, or two or more kinds thereof may be used in combination.

Examples of hygroscopic filler include uncalcined hydrotalcite, half-calcined hydrotalcite, calcined hydrotalcite, calcium oxide, magnesium oxide, calcined dolomite (mixture containing calcium oxide and magnesium oxide), calcium hydride, strontium oxide, aluminum oxide, barium oxide, molecular sieve, silica, and the like. The hygroscopic filler is preferably at least one selected from the group consisting of half-calcined hydrotalcite, calcium oxide, and calcium hydride, more preferably at least one selected from the group consisting of half-calcined hydrotalcite and calcium oxide.

Hydrotalcite can be classified into uncalcined hydrotalcite, half-calcined hydrotalcite, and calcined hydrotalcite.

The uncalcined hydrotalcite is, for example, a metal hydroxide having a layered crystal structure represented by natural hydrotalcite ($Mg_6Al_2(OH)_{16}CO_3 \cdot 4H_2O$), and composed of a layer $[Mg_{1-x}Al_x(OH)_2]^{x+}$ to be the basic skeleton and an intermediate layer $[(CO_3)_{x/2} \cdot mH_2O]^{x-}$. The uncalcined hydrotalcite is a concept including hydrotalcite-like compounds such as synthetic hydrotalcite and the like. Examples of the hydrotalcite-like compound include those represented by the following formula (I) and the following formula (II).

$$[M^{2+}_{1-x}M^{3+}_x (O_H)_2]^{x+} \cdot [(A^{n-})_{x/n} \cdot mH_2O]^{x-} \qquad (I)$$

wherein $M^{2+}$ is a divalent metal ion such as $Mg^{2+}$, $Zn^{2+}$ or the like, $M^{3+}$ is a trivalent metal ion such as $Al^{3+}$, $Fe^{3+}$ or the like, $A^{n-}$ is an n valent anion such as $CO_3^{2-}$, $Cl^-$, $NO_3^-$ or the like, $0<x<1$, $0\leq m<1$, and n is a positive number.

In the formula (I), $M^{2+}$ is preferably $Mg^{2+}$, $M^{3+}$ is preferably $Al^{3+}$, and $A^{n-}$ is preferably $CO_3^{2-}$.

$M^{2+}_xAl_2(OH)_{2x+6-nz}(A^{n-})_z\cdot mH_2O$ (II) wherein $M^{2+}$ is a divalent metal ion such as $Mg^{2+}$, $Zn^{2+}$ or the like, $A^{n-}$ is an n valent anion such as $CO_3^{2-}$ $Cl^-$, $NO_3^-$ or the like, x is a positive number of two or more, z is a positive number of two or below, m is a positive number, and n is a positive number.

In the formula (II), $M^{2+}$ is preferably $Mg^{2+}$, and $A^{n-}$ is preferably $CO_3^{2-}$.

The half-calcined hydrotalcite refers to a metal hydroxide having a layered crystal structure in which the amount of interlayer water is decreased or eliminated, which is obtained by calcination of uncalcined hydrotalcite. The "interlayer water" refers to, when described using a composition formula, "$H_2O$" described in the composition formulas of the aforementioned uncalcined natural hydrotalcite and hydrotalcite-like compound.

On the other hand, the calcined hydrotalcite refers to a metal oxide having an amorphous structure in which not only the interlayer water but also the hydroxyl group are eliminated by condensation dehydration, and the metal oxide is obtained by calcination of uncalcined hydrotalcite or half-calcined hydrotalcite.

The uncalcined hydrotalcite, half-calcined hydrotalcite, and calcined hydrotalcite can be distinguished by the saturated water absorption rate. The saturated water absorption rate of the half-calcined hydrotalcite is not less than 1% by mass and less than 20% by mass. The saturated water absorption rate of the uncalcined hydrotalcite is less than 1% by mass, and the saturated water absorption rate of the calcined hydrotalcite is not less than 20% by mass.

The "saturated water absorption rate" refers to the mass increase rate with respect to an initial mass, when 1.5 g of a measurement sample (e.g., half-calcined hydrotalcite) is weighed with a balance and, after measuring the initial mass thereof, left standing in a compact environmental test chamber (SH-222 manufactured by ESPEC CORP.) set to 60°C, 90%RH (relative humidity) for 200 hr under atmospheric pressure. It can be determined by the following formula (i):

saturated water absorption rate (% by mass) = 100 x (mass after moisture absorption - initial mass)/initial mass        (i)

The saturated water absorption rate of the half-calcined hydrotalcite is preferably not less than 3% by mass and less than 20% by mass, more preferably not less than 5% by mass and less than 20% by mass.

In addition, the uncalcined hydrotalcite, half-calcined hydrotalcite, and calcined hydrotalcite can be distinguished by thermogravimetric reduction rate measured by thermogravimetric analysis. The thermogravimetric reduction rate of the half-calcined hydrotalcite at 280°C is less than 15% by mass, and the thermogravimetric reduction rate at 380°C is not less than 12% by mass. On the other hand, the thermogravimetric reduction rate of the uncalcined hydrotalcite at 280°C is not less than 15% by mass, and the thermogravimetric reduction rate of the calcined hydrotalcite at 380°C is less than 12% by mass.

The thermogravimetric analysis can be performed using TG/DTA EXSTAR6300 manufactured by Hitachi High-Tech Science Corporation, by weighing 5 mg of hydrotalcite in an aluminum sample pan which is open without a lid, and standing same under the conditions of atmosphere with a nitrogen flow at 200 mL/min at a temperature rise rate of 10°C/min from 30°C to 550°C. The thermogravimetric reduction rate can be determined by the following formula (ii):

thermogravimetric reduction rate (% by mass) = 100 x (mass before heating - mass when given temperature is reached)/mass before heating        (ii)

In addition, the uncalcined hydrotalcite, half-calcined hydrotalcite, and calcined hydrotalcite can be distinguished by the peak and relative intensity ratio measured by powder X-ray diffraction. The half-calcined hydrotalcite shows split two peaks or a peak with a shoulder by combining two peaks, at 2θ of about 8 to 18° by powder X-ray diffraction, and a relative intensity ratio (low-angle side diffraction intensity/high-angle side diffraction intensity) of 0.001 to 1,000 between the diffraction intensity of the peak or shoulder appearing on the low-angle side (= low-angle side diffraction intensity) and the diffraction intensity of the peak or shoulder appearing on the high-angle side (= high-angle side diffraction intensity). On the other hand, the uncalcined hydrotalcite has only one peak near 8 to 18°, or the relative intensity ratio between the diffraction intensity of the peak or shoulder appearing on the low-angle side and the diffraction intensity of the peak or shoulder appearing on the high-angle side falls outside the aforementioned range. The calcined hydrotalcite does not have a characteristic peak in the region of 8° to 18°, but has a characteristic peak at 43°. The powder X-ray diffraction was measured by a powder X-ray diffractometer (Empyrean manufactured by PANalytical) under the conditions of anticathode CuKα (1.5405Å), voltage: 45 V, electric current: 40 mA, sampling width: 0.0260°, scan rate: 0.0657°/s, measurement diffraction angle range (2θ): 5.0131 to 79.9711°. The peak search can be performed using the peak search function of the software attached to the diffractometer and under the conditions of "minimum significance: 0.50, minimum peak chip: 0.01°, maximum peak chip: 1.00°, peak base width: 2.00°, method: secondary differential minimum".

The BET specific surface area of the half-calcined hydrotalcite is preferably 1 to 250 $m^2/g$, more preferably 5 to 200 $m^2/g$. The BET specific surface area thereof can be obtained by adsorbing nitrogen gas to the sample surface according to the BET method and using a specific surface area measuring apparatus (Macsorb HM Model-1210 manufactured by Mountech Co., Ltd.), and calculating by the BET multipoint method.

The particle size of the half-calcined hydrotalcite is preferably 1 to 1,000 nm, more preferably 10 to 800 nm. The particle size thereof is the median diameter of particle size distribution when the particle size distribution is prepared by laser diffraction scattering particle size distribution measurement (JIS Z 8825) based on volume.

As the half-calcined hydrotalcite, those surface-treated with a surface treating agent can be used. As a surface treating agent to be used for the surface treatment, for example, higher fatty acid, alkylsilanes, silane coupling agent, or the like can be used, of which higher fatty acid and alkylsilanes are preferred. One or more kinds of the surface treating agents can be used.

As the half-calcined hydrotalcite, a commercially available product can be used. Examples of the commercially available product include "DHT-4C" and "DHT-4A-2" which are manufactured by Kyowa Chemical Industry Co., Ltd., and the like.

As calcium oxide, a commercially available product can be used. Examples of the commercially available product include "QC-X" manufactured by INOUE CALCIUM CORPORATION; "MOISTOP #10" manufactured by SANKYO SEIFUN Co., Ltd.; "HAL-G", "HAL-J", and "HAL-F" which are manufactured by Yoshizawa Lime Industry Co., Ltd.; "CaO Nano Powder" manufactured by Filgen, and the like.

The particle size of calcium oxide and the particle size of a mixture containing calcium oxide are each preferably 1 to 500 nm, more preferably 5 to 400 nm, further preferably 10 to 300 nm. The particle size thereof is the median diameter of particle size distribution when the particle size distribution is prepared by laser diffraction scattering particle size distribution measurement (JIS Z 8825) based on volume.

When the adhesive layer contains a hygroscopic filler, the content of the hygroscopic filler in the adhesive layer is preferably 60% by mass or less, more preferably 55% by mass or less, based on the entire adhesive layer.

The adhesive layer may contain a component different from the aforementioned components (hereinafter sometimes to be referred to as "other component") as long as the effect of the present invention is not inhibited. Examples of other component include tackifier, curing accelerator, and the like. In each of these, only one kind may be used or two or more kinds may be used in combination.

The tackifier is a component that imparts adhesiveness to an adhesive layer. In the present invention, the tackifier is not particularly limited and a known one can be used.

The softening point of the tackifier is preferably 50 to 200°C, more preferably 90 to 180°C, further preferably 100 to 150°C, from the aspect of heat resistance of the adhesive layer, and the like. The softening point is measured by the ring and ball method according to JIS K2207.

The tackifier may be a commercially available product. Examples of the commercially available product thereof include "ARKON P-90", "ARKON P-100", "ARKON P-115", "ARKON P-125", "ARKON P-140", "ARKON M-90", "ARKON M-100", "ARKON M-115", and "ARKON M-135" (all hydrogenated cyclohexane ring-containing petroleum resins) manufactured by Arakawa Chemical Industries, Ltd., and the like.

When a tackifier is used, the content of the tackifier in the adhesive layer is preferably 5 to 40% by mass, more preferably 10 to 35% by mass, based on the entire adhesive layer, from the aspect of adhesiveness.

When a tackifier is used, the content of the tackifier in the adhesive layer is preferably 15 to 45% by mass, more preferably 15 to 40% by mass, based on the total of components other than the hygroscopic filler in the adhesive layer, from the aspect of adhesiveness.

Examples of the curing accelerator include imidazole compound, tertiary/quaternary amine compound, dimethylurea compound, organic phosphine compound, and the like.

Examples of the imidazole compound include 1H-imidazole, 2-methylimidazole, 2-phenyl-4-methylimidazole, 2-ethyl-4-methylimidazole, 1-cyanoethyl-2-ethyl-4-methylimidazole, 2-undecylimidazole, 1-cyanoethyl-2-undecylimidazole, 1-cyanoethyl-2-undecylimidazolium trimellitate, 2-phenyl-4,5-bis(hydroxymethyl)imidazole, 1-benzyl-2-methylimidazole, 1-benzyl-2-phenylimidazole, 2-phenylimidazole, 2-dodecylimidazole, 2-heptadecylimidazole, 1,2-dimethylimidazole, 2-phenyl-4-methyl-5-hydroxymethylimidazole, and the like. Specific examples of the imidazole compound include CUREZOL 2 MZ, 2P4MZ, 2E4MZ, 2E4MZ-CN, C11Z, C11Z-CN, C11Z-CNS, C11Z-A, 2PHZ, 1B2MZ, 1B2PZ, 2PZ, C17Z, 1.2DMZ, 2P4MHZ-PW, 2MZ-A, and 2MA-OK (all manufactured by SHIKOKU CHEMICALS CORPORATION), and the like.

The tertiary/quaternary amine compound is not particularly limited. Examples thereof include quaternary ammonium salts such as tetramethylammonium bromide, tetrabutylammonium bromide, and the like; diazabicyclo compounds such as DBU (1,8-diazabicyclo[5.4.0]undecene-7), DBN (1,5-diazabicyclo[4.3.0]nonene-5), DBU-phenol salt, DBU-octylic acid salt, DBU-p-toluenesulfonic acid salt, DBU-formic acid salt, DBU-phenolnovolac resin salt, and the like; tertiary amines or salts thereof such as benzyldimethylamine, 2-(dimethylaminomethyl)phenol, 2,4,6-tris(dimethylaminomethyl)phenol (TAP), and the like; dimethylurea compounds such as aromatic dimethylurea, aliphatic dimethylurea, and the like; and the like.

Examples of the dimethylurea compound include aromatic dimethylureas such as DCMU (3-(3,4-dichlorophenyl)-1,1-dimethylurea), U-CAT 3512T (manufactured by San-Apro Ltd.), and the like; aliphatic dimethylureas such as U-CAT 3503N (manufactured by San-Apro Ltd.), and the like; and the like. Among these, aromatic dimethylurea is preferably used from the aspect of curability.

Examples of the organic phosphine compound include triphenyl phosphine, tetraphenylphosphonium tetra-p-tolylborate, tetraphenylphosphonium tetraphenylborate, tri-tert-butylphosphonium tetraphenylborate, (4-methylphenyl) triphenylphosphonium thiocyanate, tetraphenylphosphonium thiocyanate, butyltriphenylphosphonium thiocyanate, triphenyl phosphine triphenyl borane, and the like. Specific examples of the organic phosphine compound include TPP, TPP-MK, TPP-K, TTBuP-K, TPP-SCN, and TPP-S (all manufactured by HOKKO CHEMICAL INDUSTRY CO., LTD.), and the like.

When a curing accelerator is used, the content of the curing accelerator in the adhesive layer is preferably 0.0001 to 0.1% by mass, more preferably 0.001 to 0.05% by mass, based on the entire adhesive layer.

When a curing accelerator is used, the content of the curing accelerator in the adhesive layer is preferably 0.0001 to 0.1% by mass, more preferably 0.001 to 0.05% by mass, based on the total of components other than the hygroscopic filler in the adhesive layer.

The adhesive layer may contain a (meth)acrylic polymer. In the present specification, the "(meth)acrylic polymer" means a polymer in which the (meth)acrylic unit is the main constitutional unit (i.e., the amount of (meth)acrylic unit is the largest among all the constitutional units). From the aspect of maintaining adhesiveness under high temperature and high humidity, the content of the (meth)acrylic polymer in the adhesive layer is preferably 10% by mass based on the entire adhesive layer. It is more preferred that the adhesive layer does not contain a (meth)acrylic polymer.

The adhesive layer may contain at least one selected from the group consisting of an isobutene polymer containing (meth)acrylic units (particularly, an isobutene-isoprene copolymer containing (meth)acrylic units), an olefin-based polymer containing (meth)acrylic units, a liquid polymer containing (meth)acrylic units, and a (meth)acrylic polymer. From the aspect of maintaining adhesiveness under high temperature and high humidity, the amount of the (meth)acrylic unit in the adhesive layer is preferably 10% by mass or less, more preferably 5% by mass or less, based on the entire adhesive layer.

The adhesive layer in the electronic device of the present invention can be formed as described in the below-mentioned Example section. For example, the electronic device of the present invention can be produced by

(1) dissolving or dispersing the aforementioned components in an organic solvent to prepare a varnish,
(2) applying the obtained varnish onto a support (e.g., a release-treated poly(ethylene terephthalate) film) to form a coated film,
(3) heating the obtained coated film to remove the organic solvent to produce an adhesive sheet having the support and an adhesive layer formed thereon,
(4) adhering the adhesive sheet to a barrier film such that the adhesive layer and the barrier film are in contact with each other to produce a barrier film-containing sheet,
(5) peeling the support off from the barrier film-containing sheet, and adhering the adhesive layer and a flexible substrate with an electronic element formed thereon, such that the adhesive layer is in contact with the surface of the flexible substrate opposite to the surface with the electronic element formed thereon.

The conditions for the aforementioned steps (1) to (5) can be appropriately set by a person skilled in the art with reference to the description in the below-mentioned Example section and to common technical knowledge. In the aforementioned step (4), the adhesive layer may be adhered to the barrier film such that the adhesive layer is in contact with the barrier layer of the barrier film, or the adhesive layer may be adhered to the barrier film such that the adhesive layer is in contact with the substrate of the barrier film.

The electronic device of the present invention has a barrier film. In the present specification, the "barrier film" refers to a film having a water vapor transmission rate (hereinafter sometimes to be abbreviated as "WVTR") of 0.01 $(g/m^2/day)$ or less. In the present specification, the water vapor transmission rate refers to the amount of water vapor (g) that passes through 1 $m^2$ of film in one day (24 hr). In the present specification, the water vapor transmission rate is a value measured by the MOCON method (JIS K 7129-2) under the conditions of temperature 40°C and humidity 90% RH.

The WVTR of the barrier film is preferably 0.005 $(g/m^2/day)$ or less, more preferably 0.001 $(g/m^2/day)$ or less, further preferably 0.0005 $(g/m^2/day)$ or less. The lower limit of the WVTR of the barrier film is not particularly limited and a lower value is preferred, and 0 $(g/m^2/day)$ is most preferred.

The barrier film is preferably a film having a substrate and a barrier layer. Here, the substrate means the part other than the barrier layer in the aforementioned film.

The substrate may be a single layer film or a laminated film. For example, the substrate may have a laminate structure in which plastic films are laminated using an adhesive. The adhesive is not particularly limited, and a commercially available adhesive can be used.

Examples of the substrate include plastic films of polyolefins such as polyethylene, polypropylene (PP), and the like, polyesters such as poly(ethylene terephthalate) (PET), poly(ethylene naphthalate) (PEN), and the like, polycarbonate (PC), polyimide (PI), cycloolefin polymer (COP), polyvinyl chloride, and the like. Only one kind of plastic film may be used, or two or more kinds thereof may be used in combination. The substrate is preferably a poly(ethylene terephthalate) film, a cycloolefin polymer film, a poly(ethylene naphthalate) film or a polycarbonate film, more preferably a poly(ethylene terephthalate) film or a cycloolefin polymer film.

The thickness of the substrate (i.e., a portion other than a barrier layer in a film having the aforementioned barrier layer) is preferably 10 to 150 $\mu$m, more preferably 15 to 125 $\mu$m, further preferably 20 to 100 $\mu$m.

Examples of the barrier layer include metal foils (e.g., aluminum foil, copper foil), inorganic films composed of two or more kinds of atoms selected from the group consisting of a silicon atom, an oxygen atom, a nitrogen atom, and a carbon atom (e.g., silica vapor deposited film, silicon nitride film, silicon oxide film), organic-inorganic mixed films containing an inorganic substance such as metal oxide and the like and an organic substance such as organic resin and the like, and the like. The barrier film may have multiple barrier layers.

The barrier film may have a multi-layer structure in which an inorganic film and a substrate are alternately laminated. In particular, when the inorganic film is formed by chemical vapor deposition or physical vapor deposition, the film preferably has a multi-layer structure in which the inorganic film and the substrate are alternately laminated, in order to prevent cracks in the inorganic film.

The thickness of the barrier layer (when barrier film has multiple barrier layers, the total thickness thereof) is preferably 10 to 5500 nm, more preferably 50 to 5000 nm.

The barrier film may be a commercially available product. Examples of the commercially available product include "PET TSUKI AL1N30" manufactured by Toyo Aluminium K.K., "X-BARRIER" manufactured by Mitsubishi Plastics, Inc., "Verreal" manufactured by REIKO Co., Ltd., and "3EC-III" manufactured by MITSUI KINZOKU.

The barrier film is preferably a transparent barrier film. The total light transmittance of the barrier film is preferably 80% or more, more preferably 85% or more. The total light transmittance in the present specification is a value measured by the method described in <Measurement of total light transmittance> in the Example section. An example of a commercially available transparent barrier film is "Belear" manufactured by Reiko Co., Ltd.

The electronic device of the present invention has a flexible substrate. The flexible substrate is preferably a plastic substrate, more preferably a plastic substrate without a barrier layer. Examples of the substrate include poly(ethylene terephthalate) (PET), polyimide (PI), polycarbonate (PC), cycloolefin polymer (COP), and the like. The plastic substrate may be formed from a single layer plastic film, or may be formed from a multi-layer plastic film. The thickness of the flexible substrate (when formed from the plastic film of the multi-layer, the entire thickness thereof) is not particularly limited, but is preferably 10 to 250 $\mu$m, more preferably 15 to 200 $\mu$m, from the aspect of folding resistance.

The electronic device of the present invention has an electronic element. In the present specification, the "electronic element" means an electronic component formed on a substrate (flexible substrate in the present invention), and examples thereof include organic light-emitting diode (OLED) element, photoelectric conversion element, and the like. In the field of electronic devices, electronic components including substrates are sometimes called electronic elements; however, in the present specification, the electronic device refers to electronic components excluding substrates. The electronic device of the present invention having an OLED element is an organic electroluminescence (EL) device, and the electronic device of the present invention is a solar cell having a photoelectric conversion element. Examples of the solar cell include organic thin-film solar cell (OPV), perovskite solar cell (PSC), dye-sensitized solar cell (DSSC), and the like.

In the present invention, the electronic element (e.g., OLED element, photoelectric conversion element) is not particularly limited, and any known element can be used. In addition, the configuration of the electronic element and a production method thereof are known, and a person skilled in the field of electronic devices can produce the electronic element as appropriate. The electronic element may include a transparent electrode (e.g., indium tin oxide (ITO)).

The electronic device of the present invention has a sealing layer that seals the electronic element.

The sealing layer contains a polymer as a matrix. The aforementioned polymer may be any of a thermoplastic resin, a thermosetting resin, and a rubber.

The electronic device of the present invention may have an inorganic film between the electronic element and the sealing layer. The inorganic film has water vapor barrier property and can suppress moisture from penetrating into the inside. Examples of the inorganic film include inorganic films composed of two or more kinds of atoms selected from the group consisting of a silicon atom, an oxygen atom, a nitrogen atom, and a carbon atom (e.g., silica vapor deposited film, silicon nitride film, silicon oxide film), organic-inorganic mixed films containing an inorganic substance such as metal oxide and the like and an organic substance such as organic resin and the like, and the like.

The sealing layer preferably contains an isobutene polymer (particularly, an isobutene-isoprene copolymer (i.e., butyl rubber)) for folding resistance. The description of the isobutene polymer in the sealing layer is the same as that of the aforementioned adhesive layer.

When an isobutene polymer is used, the content of the isobutene polymer in the sealing layer is preferably 20 to 50% by mass, more preferably 25 to 50% by mass, based on the entire sealing layer, from the aspect of folding resistance.

When an isobutene polymer is used, the content of the isobutene polymer in the sealing layer is preferably 50 to 80% by mass, more preferably 55 to 80% by mass, based on the total of components other than the hygroscopic filler in the sealing layer, from the aspect of folding resistance.

When an isobutene-isoprene copolymer is used, the content of the isobutene-isoprene copolymer in the sealing layer is preferably 5 to 40% by mass, more preferably 5 to 35% by mass, based on the entire sealing layer, from the aspect of folding resistance.

When an isobutene-isoprene copolymer is used, the content of the isobutene-isoprene copolymer in the sealing layer is preferably 5 to 65% by mass, more preferably 7 to 60% by mass, based on the total of components other than the hygroscopic filler in the sealing layer, from the aspect of folding resistance.

The sealing layer preferably contains crosslinked polymer (A) for folding resistance. The description of the crosslinked polymer (A) in the sealing layer is the same as that of the aforementioned adhesive layer.

When crosslinked polymer (A) is used, the content of the crosslinked polymer (A) in the sealing layer is preferably 5 to 40% by mass, more preferably 10 to 35% by mass, based on the entire sealing layer, from the aspect of folding resistance.

When crosslinked polymer (A) is used, the content of the crosslinked polymer (A) in the sealing layer is preferably 5 to 65% by mass, more preferably 10 to 60% by mass, based on the total of components other than the hygroscopic filler in the sealing layer, from the aspect of folding resistance.

The sealing layer preferably contains a liquid polymer for adhesiveness. The description of the liquid polymer in the sealing layer is the same as that for the aforementioned adhesive layer.

When a liquid polymer is used, the content of the liquid polymer in the sealing layer (when both a liquid polyolefin-based resin and liquid rubber are used, the total content of these) is preferably 10 to 40% by mass, more preferably 15 to 35% by mass, based on the entire sealing layer, from the aspect of adhesiveness.

When a liquid polymer is used, the content of the liquid polymer in the sealing layer is preferably 15 to 60% by mass, and more preferably 20 to 55% by mass, based on the total of components other than the hygroscopic filler in the sealing layer, from the aspect of folding resistance.

The sealing layer preferably contains a hygroscopic filler in order to achieve good water vapor barrier property. The description of the hygroscopic filler in the sealing layer (excluding the description of the particle size of calcium oxide and the particle size of the mixture containing calcium oxide described later) is the same as that for the aforementioned adhesive layer.

When calcium oxide and/or a mixture containing calcium oxide are/is used in the sealing layer, the particle sizes thereof are each preferably 0.03 to 20 $\mu$m, more preferably 0.05 to 15 $\mu$m, further preferably 0.1 to 10 $\mu$m. The particle size thereof is the median diameter of particle size distribution when the particle size distribution is prepared by laser diffraction scattering particle size distribution measurement (JIS Z 8825) based on volume.

When a hygroscopic filler is used, the content of the hygroscopic filler in the sealing layer is preferably 40 to 70% by mass, more preferably 40 to 60% by mass, based on the entire sealing layer, from the aspect of water vapor barrier property.

The sealing layer may contain other components (e.g., tackifier, curing accelerator, etc.) like the adhesive layer. The description of other components in the sealing layer is the same as that for the aforementioned adhesive layer.

When a tackifier is used, the content of the tackifier in the sealing layer is preferably 5 to 35% by mass, more preferably 10 to 30% by mass, based on the entire sealing layer, from the aspect of adhesiveness.

When a tackifier is used, the content of the tackifier in the sealing layer is preferably 15 to 45% by mass, more preferably 15 to 40% by mass, based on the total of components other than the hygroscopic filler in the sealing layer, from the aspect of adhesiveness.

When a curing accelerator is used, the content of the curing accelerator in the sealing layer is preferably 0.0001 to 0.1% by mass, more preferably 0.001 to 0.05% by mass, based on the entire sealing layer.

When a curing accelerator is used, the content of the curing accelerator in the sealing layer is preferably 0.0001 to 0.1% by mass, more preferably 0.001 to 0.05% by mass, based on the total of components other than the hygroscopic filler in the sealing layer.

The sealing layer may contain a (meth)acrylic polymer, as in the adhesive layer. When the sealing layer contains a (meth)acrylic polymer, the content of the (meth)acrylic polymer in the sealing layer is preferably 10% by mass or less based on the entire sealing layer, from the aspect of maintaining adhesiveness under high temperature and high humidity. It is more preferable that the sealing layer does not contain a (meth)acrylic polymer.

The sealing layer may contain at least one selected from the group consisting of an isobutene polymer containing (meth)acrylic units (particularly, isobutene-isoprene copolymer containing (meth)acrylic units), an olefin-based polymer containing (meth)acrylic units, a liquid polymer containing (meth)acrylic units, and a (meth)acrylic polymer. From the aspect of maintaining adhesiveness under high temperature and high humidity, the amount of the (meth)acrylic unit in the sealing layer is preferably 10% by mass or less, more preferably 5% by mass or less, based on the entire adhesive layer.

The sealing layer in the electronic device of the present invention can be formed as described in the below-mentioned Example section. For example, the electronic device of the present invention can be produced by

(1) dissolving or dispersing the aforementioned components in an organic solvent to prepare a varnish,
(2) applying the obtained varnish onto a support to form a coated film,
(3) heating the obtained coated film to remove the organic solvent to produce a sealing sheet having the support and a sealing layer formed thereon, and
(4) adhering the sealing layer to a flexible substrate such that the electronic element and the sealing layer are in contact with each other.

The conditions in the aforementioned steps (1) to (4) can be appropriately set by a person skilled in the art with reference to the description in the below-mentioned Example section and to common technical knowledge. In addition, the support used in preparing the sealing sheet may be peeled off from the electronic device of the present invention, or may be left in the electronic device of the present invention. For example, when a barrier film is used as the aforementioned support, it is preferable to leave the aforementioned barrier film (support) in the electronic device of the present invention in order to protect the electronic element from water vapor. The description of this barrier film is as described above.

[Example]

While the present invention is explained in more detail in the following by referring to Examples, it is not limited by the following Examples. It is of course possible to modify the present invention as long as it is compatible to the above-mentioned and the below-mentioned gist and practice the present invention, all of which are encompassed in the technical scope of the present invention. Unless otherwise indicated, "parts" and "%" in the amounts of the components respectively mean "parts by mass" and "% by mass".

<Components, etc.>

The components of the adhesive layer and the acrylic adhesive films used in the Examples and Comparative Examples are shown below.

"ER829" (manufactured by SEIKO PMC CORPORATION, glycidyl methacrylate-modified propylene-butene random copolymer, propylene unit/butene unit: 71%/29%, epoxy group concentration: 0.67 mmol/g, number average molecular weight: 180,000, amount of (meth)acrylic unit in the entire copolymer: 9.5%)

"ER866" (manufactured by SEIKO PMC CORPORATION, glycidyl methacrylate-modified butyl rubber (glycidyl methacrylate-modified isobutene-isoprene copolymer), epoxy group concentration: 1.63 mmol/g, number average molecular weight: 113,000, isobutene unit/isoprene unit: 98.9%/1.1%, amount of (meth)acrylic unit in the entire copolymer: 23%)

"ER645" (manufactured by SEIKO PMC CORPORATION, maleic anhydride-modified propylene-butene random copolymer, propylene unit/butene unit: 71%/29%, acid anhydride group concentration: 2.01 mmol/g, number average molecular weight: 58,000)

"ER661" (manufactured by SEIKO PMC CORPORATION, maleic anhydride-modified butyl rubber (maleic anhydride-modified isobutene-isoprene copolymer), acid anhydride group concentration: 0.77 mmol/g, number average molecular weight: 40,000, isobutene unit/isoprene unit: 98.9%/1.1%)

"HV-300M" (manufactured by TOHO CHEMICAL INDUSTRY COMPANY, LIMITED, maleic anhydride-modified polyisobutene, acid anhydride group concentration: 0.77 mmol/g, number average molecular weight: 2,100, amount of isobutene unit in the entire constitutional units (repeating units): 100%)

"HV-1900" (manufactured by ENEOS, liquid polyisobutene, number average molecular weight: 2,900, viscosity at 25°C: 460Pa· s, amount of isobutene unit in the entire constitutional units (repeating units): 100%)

"BI-2000" (manufactured by Nippon Soda Co., Ltd., liquid hydrogenated polybutadiene, number average molecular weight: 2,200, viscosity at 45°C: 5 to 10 Pa·s)

"ARKON P-125" (manufactured by Arakawa Chemical Industries, Ltd., tackifier (hydrogenated cyclohexane ring-containing petroleum resin), softening point: 125°C)

"DHT-4C" (manufactured by Kyowa Chemical Industry Co., Ltd., half-calcined hydrotalcite, particle size (median size): 400 nm, BET specific surface area: 15 $m^2/g$)

calcium oxide (manufactured by Yoshizawa Lime Industry Co., Ltd., particle size (median size): 2.1 $\mu$m)

"TAP" (manufactured by Kayaku Nouryon Corporation, curing accelerator (2,4,6-tris(dimethylaminomethyl)phenol))

"PD-S1" (manufactured by PANAC CO.,LTD., acrylic adhesive film, thickness: 25 $\mu$m)

<Films>

poly(ethylene terephthalate) (PET) film ("Lumirror R80" manufactured by Toray Industries, Inc., thickness: 38 $\mu$m, water vapor transmission rate: 20 g/m$^2$/day (by MOCON method under the conditions of temperature 40°C and humidity 90%RH), total light transmittance (JIS K 7136): 88.0%)

barrier film (manufactured by REIKO Co., Ltd. "Verreal 38UD001", substrate: poly(ethylene terephthalate) (PET) film, substrate thickness: 38 $\mu$m, water vapor transmission rate: $5 \times 10^{-4}$ g/m$^2$/day (by MOCON method under the conditions of temperature 40°C and humidity 90%RH), total light transmittance (JIS K 7136): 90.7%)

composite film provided with aluminum foil and poly(ethylene terephthalate) (PET) ("PET TSUKI AL1N30" manufactured by Toyo Tokai Aluminium Hanbai K.K., aluminum foil thickness: 30 $\mu$m, PET thickness: 25 $\mu$m, water vapor transmission rate: $10^{-5}$ g/m$^2$/day (by MOCON method under the conditions of temperature 40°C and humidity 90% RH))

<Production Example 1>

A varnish with a mixing ratio shown in Table 1 was produced by the following steps, and an adhesive sheet was produced using the obtained varnish. The amount (part) of each component listed in the following Table indicates the non-volatile content of each component in the varnish.

Specifically, an Ipsol solution (non-volatile content: 60%) of a tackifier (tackifier, manufactured by Arakawa Chemical Industries, Ltd. "ARKON P-125"), maleic anhydride-modified polyisobutene ("HV-300M" manufactured by TOHO CHEMICAL INDUSTRY COMPANY, LIMITED), liquid polyisobutene ("HV-1900" manufactured by ENEOS), a toluene solution (non-volatile content: 25%) of glycidyl methacrylate-modified butyl rubber ("ER866" manufactured by SEIKO PMC CORPORATION), a toluene solution (non-volatile content: 35%) of maleic anhydride-modified butyl rubber ("ER661" manufactured by SEIKO PMC CORPORATION), a curing accelerator (TAP, manufactured by Kayaku Nouryon Corporation), and toluene were blended, and the obtained mixture was uniformly dispersed in a high-speed rotary mixer to give a varnish. The obtained varnish was uniformly applied with a die coater to the release-treated surface of a poly(ethylene terephthalate) (PET) film ("SP4020" manufactured by TOYO CLOTH CO., LTD., thickness of PET film: 50 $\mu$m) treated with a silicone-based release agent, and heated at 130°C for 30 min to give an adhesive sheet having a 20 $\mu$m-thick adhesive layer.

<Production Example 2>

Using a three-roll mill, maleic anhydride-modified polyisobutene ("HV-300M" manufactured by TOHO CHEMICAL INDUSTRY COMPANY, LIMITED), liquid polyisobutene ("HV-1900" manufactured by ENEOS), half-calcined hydrotalcite ("DHT-4C" manufactured by Kyowa Chemical Industry Co., Ltd.) were dispersed in an Ipsol solution (non-volatile content:60%) of a tackifier (manufactured by Arakawa Chemical Industries, Ltd. "ARKON P-125") to give a mixture. The obtained mixture, glycidyl methacrylate-modified butyl rubber ("ER866" manufactured by SEIKO PMC CORPORATION), maleic anhydride-modified butyl rubber ("ER661" manufactured by SEIKO PMC CORPORATION), a curing accelerator (TAP, manufactured by Kayaku Nouryon Corporation), and toluene were blended, and the obtained mixture was uniformly dispersed in a high-speed rotary mixer to give a varnish. The obtained varnish was uniformly applied with a die coater to the release-treated surface of a poly(ethylene terephthalate) (PET) film (manufactured by TOYO CLOTH CO., LTD. "SP4020", thickness of PET film: 50 $\mu$m) treated with a silicone-based release agent, and heated at 130°C for 30 min to give an adhesive sheet having a 20 $\mu$m-thick adhesive layer.

<Production Example 3>

In the same manner as in Production Example 2 except that the amount of half-calcined hydrotalcite ("DHT-4C" manufactured by Kyowa Chemical Industry Co., Ltd.) was changed from 30 parts to 200 parts, a varnish and an adhesive sheet with a 20 $\mu$m-thick adhesive layer were produced.

<Production Example 4>

A toluene solution (non-volatile content: 60%) of a tackifier ("ARKON P-125" manufactured by Arakawa Chemical Industries, Ltd.), maleic anhydride-modified polyisobutene ("HV-300M" manufactured by TOHO CHEMICAL INDUSTRY COMPANY, LIMITED), liquid polyisobutene ("HV-1900" manufactured by ENEOS), calcium oxide (manufactured by Yoshizawa Lime Industry Co., Ltd., particle size (median size): 2.1 $\mu$m), and toluene were blended to obtain a mixture for a pulverization treatment(content of organic solvent in the entire mixture (i.e., total content of Swazol and toluene): 24%, content of maleic anhydride-modified liquid polyisobutene: 4%, calcium oxide content: 22%, tackifier content: 20%, liquid polyisobutene content: 30%).

The mixture for a pulverization treatment was placed in a wet bead mill (LABSTAR Mini "LMZ015" manufactured by Ashizawa Finetech Ltd.), and beads (bead diameter: 0.2 mm) were filled to about 60% by volume of the effective volume of the pulverization chamber. A pulverization treatment was performed to obtain a mixture after pulverization treatment, in which calcium oxide was pulverized and dispersed.

A small amount was taken from the mixture after a pulverization treatment and diluted 100 times with toluene to prepare a measurement sample, and the median size of calcium oxide was measured and calculated by dynamic light scattering using a nanoparticle size analyzer "NANOTRAC WAVE" manufactured by MICROTRAC. As a result, the median size of calcium oxide was 246 nm.

The mixture after a pulverization treatment was blended with glycidyl methacrylate-modified butyl rubber ("ER866" manufactured by SEIKO PMC CORPORATION) and a curing accelerator (TAP, manufactured by Kayaku Nouryon Corporation), and the obtained mixture was mixed in a high-speed rotary mixer to give a varnish.

The obtained varnish was uniformly applied with a die coater to the release-treated surface of the first laminated film, and heated at 150°C for 10 min to give an adhesive sheet having a 10 $\mu$m-thick adhesive layer.

<Production Example 5>

In the same manner as in Production Example 2 except that glycidyl methacrylate-modified butyl rubber ("ER866" manufactured by SEIKO PMC CORPORATION) was changed to a toluene solution (non-volatile content: 25%) of glycidyl methacrylate-modified propylene-butene copolymer ("ER829" manufactured by SEIKO PMC CORPORATION), maleic anhydride-modified butyl rubber ("ER661" manufactured by SEIKO PMC CORPORATION) and maleic anhydride-modified polyisobutene ("HV-300M" manufactured by TOHO CHEMICAL INDUSTRY COMPANY, LIMITED) were changed to an Ipsol solution (non-volatile content: 35%) of maleic anhydride-modified propylene-butene copolymer ("ER645" manufactured by SEIKO PMC CORPORATION), liquid polyisobutene "HV-1900" was changed to liquid hydrogenated polybutadiene (manufactured by Nippon Soda Co., Ltd. "BI-2000"), and the amount of each component in the adhesive layer was changed as shown in Table 1, a varnish and an adhesive sheet with a 20 $\mu$m-thick adhesive layer were produced.

<Production Example 6>

In the same manner as in Production Example 2 except that 30 parts of half-calcined hydrotalcite was changed to 150 parts of calcium oxide (manufactured by Yoshizawa Lime Industry Co., Ltd., particle size (median size): 2.1 $\mu$m), a varnish and a sealing sheet with a 50 $\mu$m-thick sealing layer were produced.

<Formation of calcium (Ca) film>

A calcium (Ca) film, instead of an electronic element, was formed on the substrates (i.e., substrate A, substrate B, multi-layer substrate C) with the constitutions shown in Table 2 to produce electronic device models.

In detail, 50 mm×50 mm substrate A or B was prepared, and each substrate was washed for 5 min with boiled isopropyl alcohol, treated with UV ozone, and dried at 100°C for 30 min or more in a nitrogen environment. Calcium (Ca) film was vapor-deposited on one surface of the dried substrate by using a mask covering the peripheral area at a distance of 0 mm to 0.1 mm from the end of the substrate. As a result, a 200 nm-thick Ca film (purity: 99.8%) was formed on one surface of the substrate, in the central portion excluding the peripheral area at a distance of 0 mm to 0.1 mm from the end. In substrate B, the Ca film was formed on the barrier layer side. In multi-layer substrate C, a Ca film was formed in advance on a flexible substrate (PET film), and then an adhesive layer and a barrier film were laminated by the below-mentioned method.

<Evaluation of warpage height>

Using the substrate after Ca film formation, two adjacent sides of the four sides were fixed to a flat substrate with a tape, the height of the warpage at the corners not in contact with the tape (hereinafter referred to as "warpage height") was measured, and the warpage of the substrate after Ca film formation was evaluated according to the following criteria. The results are shown in Table 3.

(Evaluation criteria for warpage height)

○ (Good): warpage height is less than 10 mm
× (Bad): warpage height is 10 mm or more

As shown in Table 3, when the Ca film was formed directly on the barrier film (substrate B), the warpage height was 10 mm or more due to the thermal history of the film formation step (Comparative Example 2). On the other hand, when the Ca film was formed on a PET film (substrate A) not having a barrier layer (inorganic film), warping did not occur (Comparative Example 1). These results suggest that the step of directly providing an electronic element on the barrier film is not preferable. In multi-layer substrate C, a Ca film was formed on the PET film and then a barrier film was adhered via an adhesive layer to the surface of the PET film on the side opposite to the Ca film. Therefore, the barrier film was not subjected to the thermal history and warping did not occur (Comparative Examples 3 and 4, and Examples 1 to 4).

<Evaluation of water vapor barrier property>

First, a sealing sheet for sealing the Ca film, which is an electronic element model, was produced. Specifically, a composite film ("PET TSUKI AL1N30" manufactured by Toyo Tokai Aluminium Hanbai K.K., aluminum foil thickness: 30 μm, PET film thickness: 25 μm) provided with aluminum foil and polyethylene terephthalate (PET) film was laminated using a batch-type vacuum laminator (manufactured by Nikko-Materials Co., Ltd., V-160) onto the sealing layer of the sealing sheet produced in Production Example 6, whereby a sealing sheet with a laminate structure of "composite film/sealing layer of Production Example 6/protective sheet (release-treated PET film)" was produced. The lamination was performed under the conditions of temperature 80°C, time 30 seconds, and pressure 0.3 MPa.

Next, a barrier film-containing sheet for adhering the barrier film to a flexible substrate (PET film) was prepared. Specifically, in the same manner as above except that the adhesive sheet produced in Production Examples 1 to 5 or an acrylic adhesive film ("PD-S1" manufactured by PANAC CO., LTD.) was used instead of the sealing sheet in Production Example 6, an adhesive layer or an acrylic adhesive film was laminated on a barrier film ("Verreal 38UD001" manufactured by REIKO Co., Ltd.) using a batch-type vacuum laminator, whereby a barrier film-containing sheet with a laminate structure of "barrier film/adhesive layer of Production Examples 1 to 5 or acrylic adhesive film/protective sheet (release-treated PET film)" was produced.

In a nitrogen atmosphere, a sealing sheet after peeling off the protective sheet was adhered by a thermal laminator ("Lamipacker DAiSY A4(LPD2325)" manufactured by FUJIPLA) to a flexible substrate (PET film) with a Ca film formed thereon or a barrier film with a Ca film formed thereon to produce an evaluation sample for Comparative Example 1 or 2. In detail, in Comparative Example 1, an evaluation sample with a laminate structure of "composite film/sealing layer of Production Example 6/Ca film/flexible substrate (PET film)" was produced. In Comparative Example 2, an evaluation sample with a laminate structure of "composite film/sealing layer of Production Example 6/Ca film/barrier film)" was produced.

As shown in Table 3, except for Comparative Example 1 and Comparative Example 2, a barrier film was further adhered to the surface of the flexible substrate (PET film) opposite to the surface with the Ca film formed thereon, using the adhesive sheet of Production Examples 1 to 5 or an acrylic adhesive film. Specifically, the protective sheet was peeled off from the aforementioned barrier film-containing sheet, and the sheet was heated at 130°C for 30 min in order to remove the adsorbed water on the surface of the adhesive layer or acrylic adhesive film. Thereafter, an adhesive layer or an acrylic adhesive film was adhered to the surface of the flexible substrate opposite to the surface with the Ca film formed thereon, by a method similar to that in the sealing layer, whereby an evaluation sample with a laminate structure of "composite film/sealing layer of Production Example 6/Ca film/flexible substrate (PET film)/adhesive layer of Production Examples 1 to 5 or acrylic adhesive film/barrier film" was produced.

Generally, when calcium contacts water and becomes calcium oxide, it becomes transparent. In the aforementioned evaluation sample, the aluminum foil has sufficiently high water vapor barrier property. Therefore, moisture generally moves in the perpendicular direction of the substrate and in the in-plane direction (direction perpendicular to thickness direction) through the end part of the adhesive layer or acrylic adhesive film to reach the calcium film. Therefore, penetration of moisture into the evaluation sample can be evaluated by observing the degradation behavior of the calcium film. In addition, since the sealing layer of Production Example 6 contains calcium oxide, when it absorbs water and becomes calcium hydroxide, the sealing layer discolors in the same way as the calcium film. Thus, an evaluation sample containing a calcium film sealed with the sealing layer of Production Example 6 was used as a model electronic device.

The evaluation sample was stored in a constant temperature and humidity chamber set to temperature 85°C, humidity 85%RH. After lapse of 65 hr from storage, the evaluation sample was taken out from the constant temperature and humidity chamber and the distance X (mm) from the end face of the sample to the discolored part of the calcium film was measured, and the water vapor barrier property was evaluated according to the following criteria. The results are shown in Table 3.

(Evaluation criteria for water vapor barrier property)

○ (Good): X is less than 1000 μm
× (Bad): X is 10 μm or more, or Ca film disappears

<Evaluation of folding resistance>

The protective sheet was peeled off from the sealing sheet with a laminate structure of "composite film/sealing layer of Production Example 6/protective sheet (release-treated PET film)" which was produced as described above. The sealing layer of the sealing sheet was adhered to the substrate A, substrate B, or multi-layer substrate C with the constitution shown in Table 2 using a batch-type vacuum laminator to produce an evaluation sample with a length 110 mm and a width 20 mm, which has a laminate structure of "composite film/sealing layer of Production Example 6/substrate A, substrate B, or multi-layer substrate C". When multi-layer substrate C was used, it was adhered such that the flexible substrate (PET film) of multi-layer substrate C and the sealing layer of Production Example 6 were in contact with each other.

The obtained evaluation sample was placed in a clamshell-type folding tester "CL40R type-E02" (manufactured by Yuasa System Co., Ltd.) such that a compressive force was applied to the sealing layer side thereof, and the evaluation sample was folded 1,000 times under the conditions of temperature 60°C, humidity 90%RH, radius of curvature 5.0 mm, and rate 60 rpm. After folding, the distance from the edge of the sealing layer of Production Example 6, the adhesive layer of Production Examples 1 to 5, or the acrylic adhesive film to the part containing bubbles was measured using a digital microscope "VHX-5000" manufactured by KEYENCE CORPORATION (magnification: x20), and the folding resistance was evaluated using the maximum value and according to the following criteria. The results are shown in Table 3.

(Evaluation criteria for folding resistance)

○ (good): the aforementioned maximum value is less than 1 mm
Δ (acceptable): the aforementioned maximum value is 1 mm or more and less than 2 mm
× (bad): the aforementioned maximum value is 2 mm or more

<Measurement of total light transmittance>

The total light transmittance (%) of substrate A, substrate B or multi-layer substrate C was measured in accordance with JIS K 7136. In detail, the total light transmittance (%) of each substrate was measured at D65 light using a haze meter HZ-V3 (halogen lamp) manufactured by Suga Test Instruments Co., Ltd., with air as a reference. The results are shown in Table 3. As shown in Table 3, all substrates showed a total light transmittance of 85% or more.

[Table 1]

| | | adhesive layer | | | | | sealing layer |
|---|---|---|---|---|---|---|---|
| | | Production Example 1 | Production Example 2 | Production Example 3 | Production Example 4 | Production Example 5 | Production Example 6 |
| ER829 | glycidyl methacrylate-modified pro-pylene-butene random copo-lymer (parts) | | | | | 20 | |

(continued)

| | | adhesive layer | | | | | sealing layer |
| --- | --- | --- | --- | --- | --- | --- | --- |
| | | Production Example 1 | Production Example 2 | Production Example 3 | Production Example 4 | Production Example 5 | Production Example 6 |
| ER866 | glycidyl methacrylate-modified butyl rubber (parts) | 30 | 30 | 30 | 20 | | 42 |
| ER645 | maleic anhydride-modified propylene-butene random copolymer (parts) | | | | | 20 | |
| ER661 | maleic anhydride-modified butyl rubber (parts) | 90 | 70 | 50 | | | |
| ARKON P125 | tackifier (parts) | 65 | 65 | 65 | 45 | 80 | 50 |
| HV-300M | maleic anhydride-modified polyisobutene (parts) | 5 | 5 | 20 | 10 | | 20 |
| HV-1900 | liquid polyisobutene (parts) | 70 | 50 | 80 | 70 | | 50 |
| BI-2000 | liquid hydrogenated polybutadiene (parts) | | | | | 85 | |
| DHT-4C | half-calcined hydrotalcite (parts) | | 30 | 200 | | 200 | |
| CaO | calcium oxide (median size: 2.1 $\mu$m) (parts) | | | | | | 150 |
| CaO | calcium oxide (median size: 246 nm) (parts) | | | | 50 | | |
| TAP | curing accelerator (parts) | 0.01 | 0.01 | 0.01 | 0.01 | 0.01 | 0.01 |

[Table 2]

| | constitution |
| --- | --- |
| substrate A | flexible substrate (PET film "Lumirror R80") |
| substrate B | barrier film ("Verreal 38UD001") |
| multi-layer substrate C | flexible substrate (PET film "Lumirror R80")/adhesive layer/barrier film ("Verreal 38UD001") |

[Table 3]

| | Comparative Example 1 | Comparative Example 2 | Comparative Example 3 | Comparative Example 4 | Example 1 | Example 2 | Example 3 | Example 4 |
|---|---|---|---|---|---|---|---|---|
| substrate or multi-layer substrate | A | B | C | C | C | C | C | C |
| adhesive layer between substrate and barrier film | - | - | acrylic adhesive film | Production Example 5 | Production Example 1 | Production Example 2 | Production Example 3 | Production Example 4 |
| warpage height | 0 mm ○ | 15 mm × | 0 mm ○ | 0 mm ○ | 0 mm ○ | 0 mm ○ | 0 mm ○ | 0 mm ○ |
| water vapor barrier property | Ca film disappearance × | <100 μm ○ | 2190 μm × | 560 μm ○ | 570 μm ○ | 475 μm ○ | 422 μm ○ | 387 μm ○ |
| folding resistance | 0 mm ○ | 0 mm ○ | 0 mm ○ | 5.5 mm × | 0 mm ○ | 0 mm ○ | 0 mm ○ | 1.2 mm △ |
| total light transmittance of substrate or multi-layer substrate | 88.0% | 90.7% | 88.9% | 89.0% | 89.1% | 89.0% | 88.9% | 89.0% |

<Production Example of electronic device>

An OLED element (organic film thickness: 110 nm, Al cathode thickness: 100 nm) can be formed on a flexible substrate (PET substrate with indium tin oxide (ITO)) (manufactured by GEOMATEC Co., Ltd.) such that the light-emitting area is 4 mm$^2$. The OLED element can be sealed with the sealing layer of Production Example 6 by adhering the sealing sheet with a laminate structure of "composite film/sealing layer of Production Example 6" and the aforementioned substrate under a nitrogen atmosphere using a roll laminator (manufactured by FUJIPLA, LPD2325, roll material: rubber) under the conditions of roll temperature: 90°C, roll speed: 360 mm/min, and roll pressure: 0.2 MPa. Furthermore, an electronic device having a laminate structure of "composite film/sealing layer of Production Example 6/OLED element/-flexible substrate/adhesive layer of Production Example 3/barrier film" can be produced by adhering a barrier film-containing sheet with a laminate structure of "barrier film/adhesive layer of Production Example 3" to the surface of the flexible substrate opposite to the surface of the OLED element.

[Industrial Applicability]

The electronic device of the present invention is useful as an organic electroluminescence (EL) device, a solar cell, or the like.
This application is based on a patent application No. 2023-022749 filed in Japan, the contents of which are encompassed in full herein.

**Claims**

1.   An electronic device having

a flexible substrate,
an electronic element formed on the flexible substrate, and
a sealing layer that seals the electronic element,

the electronic device further comprising a barrier film provided via an adhesive layer on a surface of the flexible substrate opposite to a surface on which the electronic element is formed, and
the adhesive layer comprising a polymer comprising constitutional units derived from isobutene.

2.   The electronic device according to claim 1, wherein the adhesive layer comprises a crosslinked polymer having an isobutene-isoprene copolymer chain.

3.   The electronic device according to claim 1 or 2, wherein the adhesive layer comprises a hygroscopic filler.

4.   The electronic device according to claim 1 or 2, wherein the barrier film has a total light transmittance of 80% or more.

5.   The electronic device according to claim 1 or 2, wherein the electronic element is an organic light-emitting diode element or a photoelectric conversion element.

## INTERNATIONAL SEARCH REPORT

| | International application No. |
|---|---|
| | **PCT/JP2024/005356** |

**A. CLASSIFICATION OF SUBJECT MATTER**

*H10K 50/844*(2023.01)i; *H01L 23/14*(2006.01)i; *H10K 50/10*(2023.01)i; *H10K 77/10*(2023.01)i
FI:    H10K50/844; H10K50/10; H10K77/10; H01L23/14 R

According to International Patent Classification (IPC) or to both national classification and IPC

**B. FIELDS SEARCHED**

Minimum documentation searched (classification system followed by classification symbols)
H10K50/844; H01L23/14; H10K50/10; H10K77/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2018-520232 A (LG CHEM, LTD.) 26 July 2018 (2018-07-26)<br>claims, paragraphs [0018], [0045]-[0049], [0066], [0076], [0108]-[0113] examples 1, 2, fig. 1, 2 | 1-5 |
| A | WO 2014/115825 A1 (FUJIFILM CORPORATION) 31 July 2014 (2014-07-31)<br>entire text, all drawings | 1-5 |
| A | US 2020/0291277 A1 (3M INNOVATIVE PROPERTIES COMPANY) 17 September 2020 (2020-09-17)<br>entire text, all drawings | 1-5 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 March 2024** | **02 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/005356**

| Patent document cited in search report | | | Publication date (day/month/year) | Patent family member(s) | | | Publication date (day/month/year) |
|---|---|---|---|---|---|---|---|
| JP | 2018-520232 | A | 26 July 2018 | US | 2018/0171181 | A1 | |
| | | | | claims, paragraphs [0018], [0045]-[0049], [0066], [0075], [0105]-[0115] examples 1, 2, fig. 1, 2 | | | |
| | | | | US | 2018/0171188 | A1 | |
| | | | | US | 2018/0171179 | A1 | |
| | | | | WO | 2016/200180 | A1 | |
| | | | | WO | 2016/200176 | A1 | |
| | | | | WO | 2016/200179 | A1 | |
| | | | | KR | 10-2016-0144932 | A | |
| | | | | KR | 10-2016-0144933 | A | |
| | | | | KR | 10-2016-0144934 | A | |
| | | | | CN | 107820512 | A | |
| | | | | CN | 107849414 | A | |
| | | | | CN | 107851731 | A | |
| | | | | KR | 10-2018-0050629 | A | |
| | | | | KR | 10-2018-0051469 | A | |
| | | | | JP | 2018-524432 | A | |
| | | | | JP | 2018-525773 | A | |
| | | | | JP | 2021-5567 | A | |
| WO | 2014/115825 | A1 | 31 July 2014 | JP | 2014-143142 | A | |
| | | | | JP | 2014-179266 | A | |
| US | 2020/0291277 | A1 | 17 September 2020 | WO | 2019/111182 | A1 | |
| | | | | CN | 111465669 | A | |

Form PCT/ISA/210 (patent family annex) (July 2022)

**REFERENCES CITED IN THE DESCRIPTION**

**Patent documents cited in the description**

- JP 2019067493 A

- JP 2023022749 A